## Europäisches Patentamt

## European Patent Office

## Office européen des brevets

(19)

(11) Veröffentlichungsnummer: **0 111 698**
**B1**

(12)

# EUROPÄISCHE PATENTSCHRIFT

(45) Veröffentlichungstag der Patentschrift:
**11.05.88**

(51) Int. Cl.⁴: **G 01 R 33/06**, H 01 L 29/82 //
H01L29/62

(21) Anmeldenummer: **83110843.6**

(22) Anmeldetag: **29.10.83**

---

(54) **Magnetfeldsensor.**

---

(30) Priorität: **22.11.82 CH 6790/82**

(43) Veröffentlichungstag der Anmeldung:
**27.06.84 Patentblatt 84/26**

(45) Bekanntmachung des Hinweises auf die Patenterteilung:
**11.05.88 Patentblatt 88/19**

(84) Benannte Vertragsstaaten:
**DE FR GB IT NL**

(56) Entgegenhaltungen:
**EP - A - 0 099 979**
**DE - A - 3 133 908**
**FR - A - 2 504 272**
**GB - A - 895 629**
**GB - A - 2 029 973**
**GB - A - 2 064 140**
**US - A - 3 693 085**
**US - A - 3 800 193**
**US - A - 4 097 802**
**US - A - 4 212 041**
**US - A - 4 240 059**
**US - A - 4 309 655**

(73) Patentinhaber: **LGZ LANDIS & GYR ZUG AG,**
**CH-6301 Zug (CH)**

(72) Erfinder: **Popovic, Radivoje, Zugerstrasse 24,**
**CH-6312 Steinhausen (CH)**
Erfinder: **Baltes, Heinrich Peter, Prof., University of**
**Alberta, Edmonton Alberta T6G 2E1 (CA)**
Erfinder: **Berchier, Jean-Luc, Neudorfstrasse 32,**
**CH-6313 Menzingen (CH)**
Erfinder: **Solt, Katalin, Hofstrasse 45, CH-6300 Zug (CH)**
Erfinder: **Schneider, Gernot, Arbach 55a, CH-6340 Baar**
**(CH)**
Erfinder: **Zajc, Tomislav, Hasenbühlweg 7, CH-6300 Zug**
**(CH)**
Erfinder: **Lienhard, Heinz, Neufrauenstein 12,**
**CH-6300 Zug (CH)**

(74) Vertreter: **Müller, Hans-Jürgen, Dipl.-Ing. et al, Müller,**
**Schupfner & Gauger**
**Lucile-Grahn-Strasse 38 Postfach 80 13 69,**
**D-8000 München 80 (DE)**

## Beschreibung

Die Erfindung bezieht sich auf einen Magnetfeldsensor der im Oberbegriff des Patentanspruches 1 genannten Gattung, sowie auf bevorzugte Verwendungen desselben.

Ein Magnetfeldsensor der genannten Gattung ist bereits vorgeschlagen worden (EP-A-99 979), dabei ist die Basisschicht eines Magnetotransistors schwach mit Fremdatomen dotiert und mit einem Basiskontakt versehen, der stark mit Fremdatomen dotiert ist. Die Emitter- und Kollektorschicht und der Basiskontakt befinden sich nebeneinander auf einer Linie. Die Basisschicht ist als Wanne an der Oberfläche eines schwach mit Fremdatomen dotierten Siliciumsubstrats vom umgekehrten Material-Leitfähigkeitstyp ausgebildet. Ausserhalb der Wanne befindet sich an der Oberfläche im Siliciumsubstrat ein Kollektorsekundärkontakt, an den eine Spannung gelegt werden kann, die den PN-Übergang zwischen der Basisschicht und dem Siliciumsubstrat in Sperrrichtung polt. Die Dicke und/oder Dotierung der Emitterschicht ist so bemessen, dass ihre Resistivität grösser als 100 Ohm pro Quadrat ist.

Darüber hinaus ist es aus «Modern Electric Measuring Systems, ed by P.P.L. Regtien, Delft University Press, 1978, Chapter 1, S. Middelhoek et al., Magnetic Energy SMT's, p. 19–21 and Fig. 14 i» bekannt, NiFe- oder NiCo-Filme auf Halbleiter-Magnetfeldsensoren («Magnetic Energy Silicon Micro Transducers») aufzudampfen, um deren Temperatur-Empfindlichkeit durch Ausnutzung des Magnetoresistor-Effektes dieser Filme zu vermindern. Als Halbleiter-Magnetfeldsensoren gelten dabei: Magnetoresistoren, Hall Elemente, Magnetodioden, Magnistoren auch Magnetotransistoren genannt, Magfet's und Hall-MOSFET'S.

Darüber hinaus ist es bekannt (JP-A-57 68 092), einen MOSFET mit einem unverlierbaren Speicher als Hochgeschwindigkeitsspeicher auszubilden, bei dem die gespeicherten Daten auch bei Ausfall der Batterie bzw. Netzspannung nicht verlorengehen. Dabei werden dünne elektrisch isolierende Feritfilme verwendet.

Ferner ist es bekannt (Proc. Sensor 1982, Essen ed. by F. Durst et al., Magnetic Field Micro-Sensor based on Magneto-Resistive Comparators, p. 176–186, H.P. Baltes et al»), den Magneto-Resistoreffekt von NiFe- oder NiCo-Filmen auszunutzen.

Verglichen mit der Magnetinduktion/Magnetfeld-Schalthysterese von NiFe- oder NiCo-Filmen ist der Magnetoresistor-Effekt dieser Filme ein sekundärer und daher kleiner Effekt mit nur 1% bis 2% Widerstandsänderung beim Schalten. Brauchbare Signale werden erzielt mit sehr dünne, 200 Å dicken, und nicht zu kleinen Filmen mit einer schräg zur Richtung des angelegten Magnetfeldes $\vec{H}_a$ eingeprägten magnetischen Achse. Die technologischen Probleme so dünner Filme – Fabrikation, Zuverlässigkeit usw. – sind nicht gering. Ferner benötigen die so eingesetzten Filme eine elektrische Beschaltung mit den dadurch bedingten elektrischen Verbindungen. Die Filme werden ausserdem durch den elektrischen Strom belastet und ein erhöhtes Rauschen steht einer Miniaturisierung der Filmfläche entgegen.

Die Vermeidung magnetoresistiver Nullpunktdetektoren führt zu technologischen Vereinfachungen, die sich günstig auf die Lebensdauer der Filme und auf den Stromverbrauch auswirken; die Filme werden nicht mit hohen Stromdichten belastet, sie benötigen keine elektrischen Kontaktierungen, dürfen dicker sein und ergeben stärkere Ausgangssignale, deren Formen ausserdem noch besser definiert sind als bei der Verwendung des magnetoresistiven Effektes.

Die induktive Arbeitsweise und Detektion von NiFe- und NiCo-Filmen ist bekannt aus «Magnetic properties of materials, Chapter 8, Thin films, p. 269–339, S. Middelhoek, ed. by J. Smit, Mc Graw Hill, 1971». Ausgenutzt wird in diesem Fall das sehr gute Verhalten der Magnetinduktion/Magnetfeld-Schalthysterese dieser Filme. Sie benötigen jedoch eine komplizierte Hardware und der Magnetfeldsensor liest leicht irgendwelche Störsignale auf. Die Anforderungen nach hoher Empfindlichkeit und nach Miniaturisierung sind miteinander im Konflikt und das Ausgangssignal des Magnetfeldsensors ist annähernd nur 1 mV.

Bei Vermeidung der induktiven Detektion des Filmsignals ist die Anordnung viel einfacher und es wird die Verwendung von Induktionsspulen oder -Drähten vermieden. Es entfällt das im Falle von Induktionsspulen typische Auflesen von Störsignalen.

Reine Halbleiter-Magnetfeldsensoren, wie z.B. Magnetotransistoren, besitzen folgende Nachteile:

– eine hohe «Offset-Spannung und
– eine geringe Flankensteilheit, vor allem bei Verwendung von MOS-Technologien, und wegen Instabilitätsproblemen nur eine begrenzte Möglichkeit diese zu verbessern. Durch Schaltungskniffe, wie z.B. Verwendung einer Rückkopplung, kann diese Steilheit zwar vergrössert werden, jedoch ist die Qualität einer Magnetinduktion/Magnetfeld-Schaltkennlinie eines NiFe- bzw. eines NiCo-Filmes nie erreichbar.

Aus der Zeitschrift Sov. Phys. Semicond. 12(1), Januar 1978, Seiten 26–28, I.M. Mitnikova et al., «Investigation of the characteristics of silicon lateral magnetotransistores with two measuring collectors» ist z.B. der Aufbau und die Arbeitsweise eines Magnetotransistors bekannt.

Schliesslich ist es bekannt (Electronics Mai 1982, Seiten 45, 46), Halbleiter-Magnetfeldsensoren in Form eines Magnettransistors auszubilden.

Der Erfindung liegt die Aufgabe zugrunde, den eingangs genannten Magnetfeldsensor auf einfache Weise dahingehend zu verbessern, dass er unter Ermöglichung der Nullpunktsdetektion eine noch grössere Empfindlichkeit bei geringerer Störanfälligkeit aufweist.

Die Erfindung ist im Patentanspruch 1 gekennzeichnet und in Unteransprüchen sind weitere Ausbildungen sowie bevorzugte Verwendungen beansprucht.

Bei der Erfindung sind beispielsweise folgende Vorteile anzutreffen:

- Ausnutzung der ausgezeichneten Magnetinduktion/Magnetfeld-Hystereseschaltkennlinie von NiFe- oder NiCo-Filmen,
- Erzielung eines grossen Ausgangssignals in der Grössenordnung von 10 mV,
- Minimierung des Einflusses von Störungen und des Rauschens,
- Aufbau eines möglichst grossen Anteils des Magnetfeldsensors in Standard-Silicium-IC-Technologie und
- Vermeidung der Komplikationen der Technologie sehr dünner und Strom führender NiFe- bzw. NiCo-Filme.

Ein Ausführungsbeispiel der Erfindung ist in der Zeichnung dargestellt und wird im folgenden näher beschrieben.

Es zeigen:

Fig. 1 einen mit einem Magnetotransistor aufgebauten Magnetfeldsensor,

Fig. 2 die feldempfindliche Zone des Magnetotransistors ohne Film,

Fig. 3 die feldempfindliche Zone des Magnetotransistors mit Film,

Fig. 4 eine rechteckförmige Magnetinduktion/Magnetfeld-Hystereseschaltkennlinie eines NiFe- bzw. eines NiCo-Films.

Fig. 5 eine Magnetinduktion/Magnetfeld-Hystereseschaltkennlinie im Zentrum der feldempfindlichen Zone mit vorhandenem Film,

Fig. 6 ein Schaltbild eines Differenzverstärkers mit zwei Magnetotransistoren,

Fig. 7 einen Magnetfeldsensor mit zwei Filmen und

Fig. 8 einen Magnetfeldsensor mit zwei Filmen in einer fokussierenden Filmanordnung.

Gleiche Bezugszahlen bezeichnen in allen Figuren der Zeichnung gleiche Teile.

Der Magnetfeldsensor besteht aus einem NiFe- oder einem NiCo-Film und einem Halbleiter-Magnetfeldsensor, die zusammen auf einem Halbleitersubstrat integriert sind. Der Film dient als Nullpunktschalter unter Ausnutzung seiner Magnetinduktion/Magnetfeld-Hystereseschaltkennlinie, während sein magnetoresistiver Effekt dagegen nicht verwendet wird. Der Halbleiter-Magnetfeldsensor detektiert das Schalten des Films und zwar über die vom Film in seiner unmittelbaren Nähe erzeugte Magnetinduktion. Jeder Halbleiter-Magnetfeldsensor besitzt eine feldempfindliche Zone. Diese ist z.B. beim Magnetotransistor die Zone zwischen der Emitter-Schicht und der dieser nächstgelegenen Kollektor-Schicht.

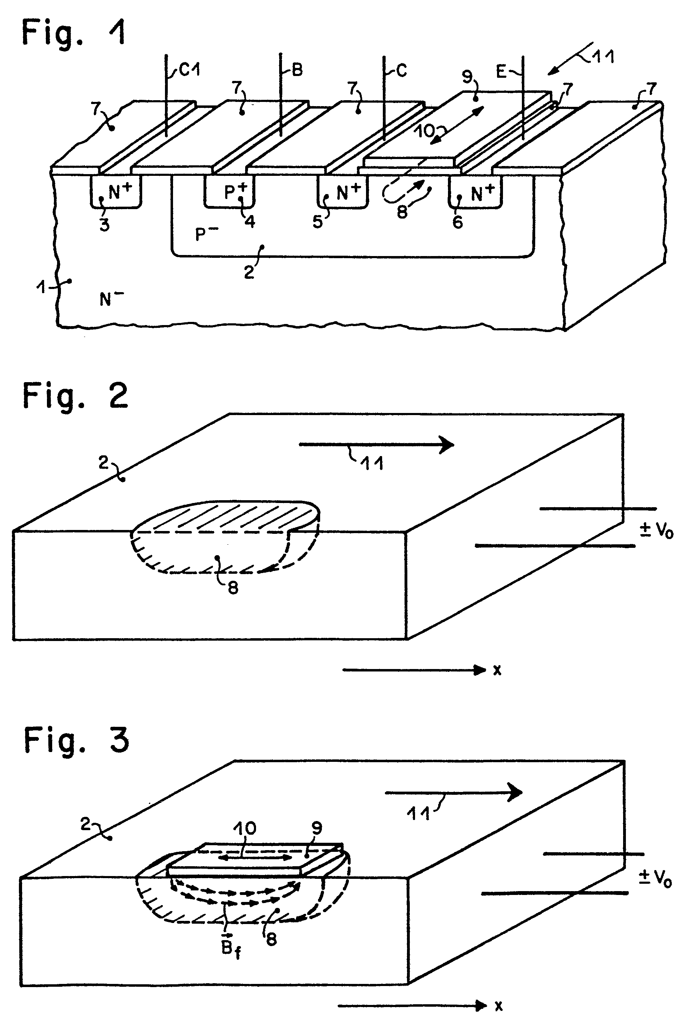

In der Fig. 1 ist eine bevorzugte Realisierung des Magnetfeldsensors wiedergegeben unter Verwendung eines Magnetotransistors.

Als Beispiel wird ein bipolarer NPN-Magnetotransistor beschrieben. Statt mit einem NPN- kann der Magnetfeldsensor jedoch auch mit einem PNP-Magnetotransistor aufgebaut werden, unter Berücksichtigung der dann üblichen und aus der Transistortechnik her bekannten Umkehrungen der Material-Leitfähigkeitstypen.

Der Magnetfelsensor kann mittels einer CMOS-Technologie hergestellt werden.

Gemäss der Fig. 1 besteht der Magnetotransistor aus einem gewöhnlichen monokristallinen Siliziumsubstrat 1 aus schwach mit Fremdatomen dotiertem N-Material, d.h. aus $N^-$-Material, dessen Resistivität annähernd ein Ohm · cm ist. Unter Verwendung bekannter Prozessschritte aus der Technologie der integrierten Schaltungen werden folgende Schichten im Siliziumsubstrat 1 an dessen Oberfläche gebildet durch Ionenimplantation und/oder durch Diffusion von Fremdatomen in das Siliziumsubstrat 1:

- eine $P^-$-Wanne aus schwach mit Fremdatomen dotiertem P-Material, also vom umgekehrten Material-Leitfähigkeitstyp als das Siliziumsubstrat 1, als Basis-Schicht 2 und
- eine in der Darstellung der Fig. 1 links von der $P^-$-Wanne angeordnete stark mit Fremdatomen dotierte $N^+$-Schicht aus N-Material zur Bildung eines Kollektor-Sekundärkontaktes 3.

Auf die gleiche Art werden in der $P^-$-Wanne an deren Oberfläche folgende Schichten erzeugt, die in der Darstellung der Zeichnung von links nach rechts nebeneinander auf einer Linie angeordnet sind:

- eine stark mit Fremdatomen dotierte $P^+$-Unterschicht als Basis-Kontakt 4,
- eine stark mit Fremdatomen dotierte erste $N^+$-Unterschicht als Kollektor-Schicht 5,
- eine stark mit Fremdatomen dotierte zweite $N^+$-Unterschicht als Emitter-Schicht 6,

Die Kollektor-Schicht 5 befindet sich also räumlich zwischen der Emitter-Schicht 6 und dem Basis-Kontakt 4.

Der Kollektorsekundärkontakt 3, der Basis-Kontakt 4, die Kollektor-Schicht 5 und die Emitter-Schicht 6 besitzen bei einer Standard-Ausführung des Magnetotransistors alle eine gleiche Tiefe, z.B. von 1 μm, eine gleich starke Dotierung mit Fremdatomen und eine Resistivität $\leq$ fünfzig Ohm pro Quadrat. Die Basis-Schicht 2 hat z.B. eine Resistivität von einem Kiloohm pro Quadrat und eine Tiefe von annähernd 10 μm. Der P/N-Übergang zwischen Siliziumsubstrat 1 und Basis-Schicht 2 ist in Sperrichtung zu polen mit Hilfe des Kollektor-Sekundärkontaktes 3 und des Basiskontaktes 4.

In einer verbesserten Ausführung des Magnetotransistors ist die Emitter-Schicht 6 viel dünner als die anderen Schichten bzw. Kontakte, jedoch dicker als 0,5 μm, und/oder so schwach mit Fremdatomen dotiert, dass ihre Resistivität grösser als hundert Ohm pro Quadrat beträgt. Im letzteren Fall muss in die Emitter-Schicht 6 an deren Oberfläche eine stark mit Fremdatomen dotierte Schicht vom gleichen Leitfähigkeitstyp wie die Emitter-Schicht 6 als ohmischer Emitter-Kontakt eindiffundiert werden.

Die restlichen strukturellen Details des Magnetotransistors sind bekannt, insbesondere ist seine ganze Oberfläche mit einer dünnen Schutzschicht, z.B. aus Silizium-Dioxyd, bedeckt, der sogenannten Passivierungsschicht 7. Die Schichten bzw. Kontakte 3, 4, 5 und 6 besitzen je einen metallenen Anschluss, nämlich in der angegebenen Reihenfolge einen Kollektor-Sekundäranschluss C1, einen Basis-Anschluss B, einen Kollektoranschluss C und einen Emitteranschluss E.

Unmittelbar oberhalb der feldempfindlichen Zone 8 des Magnetotransistors, d.h. unmittelbar oberhalb der zwischen Emitter-Schicht 6 und Kollektor-Schicht 5 gelegenen Zone, ist auf die Passivierungsschicht 7 ein dünner anisotroper magnetisch ordnender und schaltender NiFe- oder NiCo-Film 9 galvanisch, durch Aufdampfung oder durch Kathodenzerstäubung aufgetragen, und zwar so, dass seine leichte Achse («easy axis»: EA) 10 senkrecht zum in der Fig. 1 gezeichneten Querschnitt des Magnetotransistors, d.h. senkrecht zur Stromflussrichtung des Halbleiter-Magnetfeldsensors angeordnet ist.

Ein zu detektierendes Magnetfeld 11 mit dem Wert $\vec{H_a}$ wirkt parallel zu dieser leichten Achse 10.

Während bei einem induktiven Verfahren mit Filmen eine zeitliche Flussänderung d $\Phi$/dt detektiert wird, wird im vorliegenden Magnetfeldsensor die lokale Magnetinduktion $\vec{B_f}$ in der feldempfindlichen Zone 8 direkt ausgewertet und durch den Halbleiter-Magnetfeldsensor detektiert. Dies bedingt, dass der Film möglichst dicht bei dieser Zone 8 angeordnet sein muss, damit ein möglichst grosser Anteil seines Magnetflusses diese Zone 8 durchfliesst. Der Film spielt die Rolle eines Minimagneten, dessen Magnetisierungsrichtung durch den Nulldurchgang des angelegten zu detektierenden Feldes plötzlich umgekehrt wird. Dementsprechend ändert sich die Richtung des von dem Minimagneten in seiner unmittelbaren Umgebung erzeugten Magnetfeldes. Die Feldstärke beträgt einige Gauss. Die abrupte Änderung der Feldrichtung wird von dem darunter liegenden Halbleiter-Magnetfeldsensoren detektiert, der seinerseits ein entsprechendes digitales elektrisches Signal produziert.

Da der Film nicht als Magnetoresistor verwendet wird, braucht es keine elektrische Anschlüsse und somit auch keine elektrische Verbindungen zum Halbleiter-Magnetfeldsensor, d.h. zum Magnetotransistor. Dieser und der Film sind elektrisch voneinander isoliert durch die Passivierungsschicht 7.

Die Fig. 2 und die Fig. 3 zeigen schematisch die grundlegende Anordnung der feldempfindlichen Zone 8 des Halbleiter-Magnetfeldsensors. Die Leichte Achse (EA) 10 des Films 9 und das zu detektierende Magnetfeld 11 sind parallel zur x-Achse angeordnet. Die Feldlinien der vom Film 9 erzeugten Magnetinduktion $\vec{B_f}$ verlaufen ungefähr wie eingezeichnet. Diese Magnetinduktion $\vec{B_f}$ wird in der feldempfindlichen Zone 8 des Halbleiter-Magnetfeldsensors detektiert, insbesondere die Vorzeichenumkehr von $\vec{B_f}$, die von der Vorzeichenumkehr der Sättigungsmagnetisierung des Films 9 herrührt.

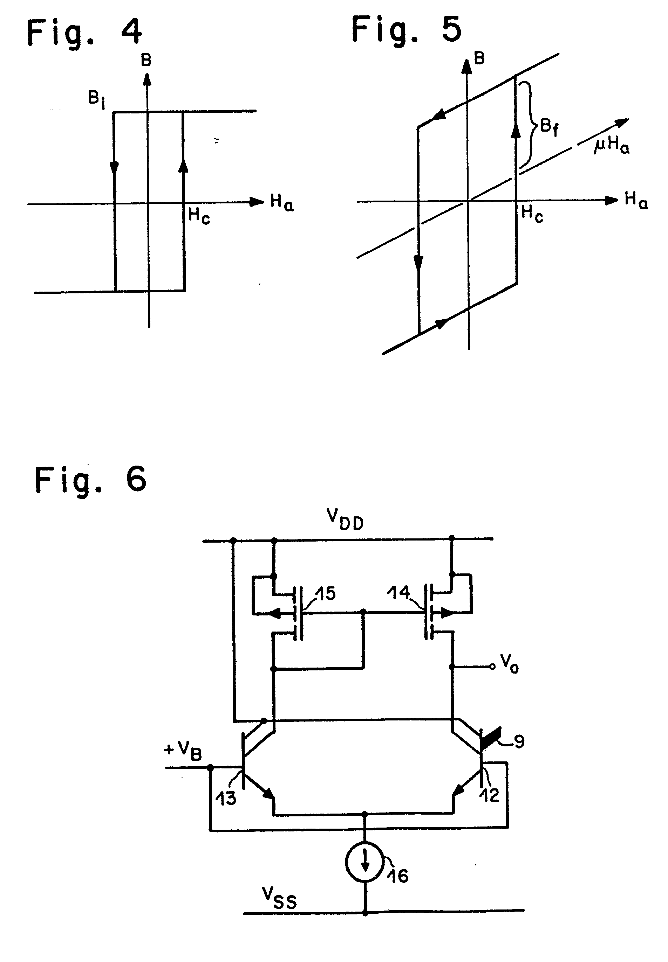

Die Hysterese des Films 9 bei Betrieb in Richtung der leichten Achse ist nahezu rechteckförmig (siehe Fig. 4). Diese Rechteckshysterese ist die wichtigste Eigenschaft der NiFe- bzw. NiCo-Filme und wird weit besser beherrscht als die Magnetoresistor-Eigenschaften. In der Fig. 4 ist die interne Magnetinduktion im Film $B_i \simeq 1$ Tesla und $H_c \simeq 10^{-4}$ Tesla.

Weil für $H_a \neq H_c$ der Film immer in der Sättigung ist, lässt sich die resultierende Flussdichte in der Umgebung des Films als lineare Superposition der vom zu detektierenden Magnetfeld 11 erzeugten Magnetinduktion $\mu\vec{H_a}$ und der vom Film erzeugten Magnetinduktion $\vec{B_f}$ darstellen:

$$\vec{B} = \mu\vec{H_a} \pm \vec{B_f}. \qquad (1)$$

Dabei ist $\mu \simeq \mu_o$ die magnetische Permeabilität des den Film 9 umgebenden Materials und $\pm\vec{B_f}$ ist die Magnetinduktion im Falle $\vec{H_a} = 0$.

Aus der Fig. 3 und der Gleichung (1) lässt sich die Magnetinduktion $\vec{B}$ in der Umgebung des Films ermitteln. Z.B. unterhalb des Films 9 in der Mitte der feldempfindlichen Zone 8 gilt angenähert

$$\vec{H_a} \parallel \vec{B_f} \parallel \vec{B} \parallel \vec{EA} \parallel x. \qquad (2)$$

Daraus resultiert der in der Fig. 5 wiedergegebene Verlauf von $\vec{B}$ in Funktion von $\vec{H_a}$.

Es lässt sich berechnen, dass z.B. für einen NiFe-Film von 50 µm Länge und 500 Å Dicke die im Abstand von einigen µm erregte Magnetinduktion ungefähr

$$B_f \simeq 10^{-3} \text{ Tesla} \qquad (3)$$

beträgt. Im Falle eines typischen Halbleiter-Magnetfeldsensors mit einer Empfindlichkeit von 10V/Tesla ergibt sich daher ein Ausganssignal mit Sprüngen von

$$\underline{\Delta V} \simeq \pm 2 \cdot B_f \cdot 10V/T$$

$$\approx \pm \underline{20 \, m} \, V, \qquad (4)$$

sobald $H_a = \pm H_c$ wird. Das gesamte Ausgangssignal des Magnetfeldsensors ist dann:

$$V_o = V + \Delta V, \qquad (5)$$

wobei V den von der direkten Detektion von $\vec{H_a}$ herrührenden Anteil, der durch die Magnetinduktion $\vec{B}$ erzeugten Ausgangsspannung bezeichnet.

Da nur $\Delta V$ interessant ist, muss V eliminiert werden, z.B. mittels eines Differenzverstärkers gemäss der Fig. 6. Dieser ist aufgebaut mittels eines ersten Magnetotransistors 12 mit Film 9 und eines zweiten Magnetotransistors 13 ohne Film, die beide je einen Lastwiderstand in Form eines MOS-Lasttransistors 14 und 15 besitzen. Die Kollektor-Sekundärkontakte beider Magnetotransistoren 12 und 13 sind miteinander verbunden und liegen am positiven Pol $V_{DD}$ einer Speisespannung. Die beiden Emitter-Schichten der Magnetotransistoren liegen über eine gemeinsame Stromquelle 16 am negativen Pol $V_{SS}$ der Speisespannung und die beiden Basis-Kontakte direkt an einer positiven Spannung $+V_B$, die so gewählt ist, dass die P/N-Übergänge «Silizium-Substrat 1/Basis-Schicht 2» der beiden Magnetotransistoren in Sperrichtung gepolt sind. Die Kollektor-Schicht des ersten Magnetotransistors 12 ist über die Source/Drain-Strecke des ersten MOS-Lasttransistors 14 und diejenige des zweiten Magnetotransistors 13 über die Source/Drain- Strecke des zweiten MOS-Lasttransistors 15 mit dem positiven Pol $V_{DD}$ der Speisespannung verbunden. Beide Gates der MOS- Lasttransistoren 14 und 15 sind auf die Kollektor-Schicht des zweiten Magnetotransistors 13 und beide Substrate dieser Lasttransistoren auf den positiven Pol $V_{DD}$ der Speisespannung geführt. Beide Magnetotransistoren 12 und 13 sind räumlich parallel angeordnet und, abgesehen vom Film 9, identisch. Die beiden MOS-Lasttransistoren 14 und 15 arbeiten als Stromspiegel, so dass beide Magnetotransistoren 12 und 13 mit einem gleichen und konstanten Kollektorstrom belastet sind, der unabhängig ist von dem Wert des anstehenden äusseren Magnetfeldes.

Die Kollektor-Schicht des ersten Magnetotransistors bildet den einpoligen Ausgang des Differenzverstärkers, an dem zusätzlich zu einer bekannten, konstanten Spannung noch die Spannung $\Delta V$ erscheint.

Neben der in der Fig. 3 gezeichneten Anordnung mit einem rechteckförmigen Film sind andere Filmgeometrien möglich und je nach Halbleiter-Magnetfeldsensor-Typ vorteilhaft, z.B. zwei Filme, die durch einen Spalt der Länge W getrennt sind, ellipsenförmige Filme (gegen Nukleation) oder fokussierende Anordnungen zur Steigerung der Empfindlichkeit für Halbleiter-Magnetfeldsensoren mit einer besonders kleinen empfindlichen Zone.

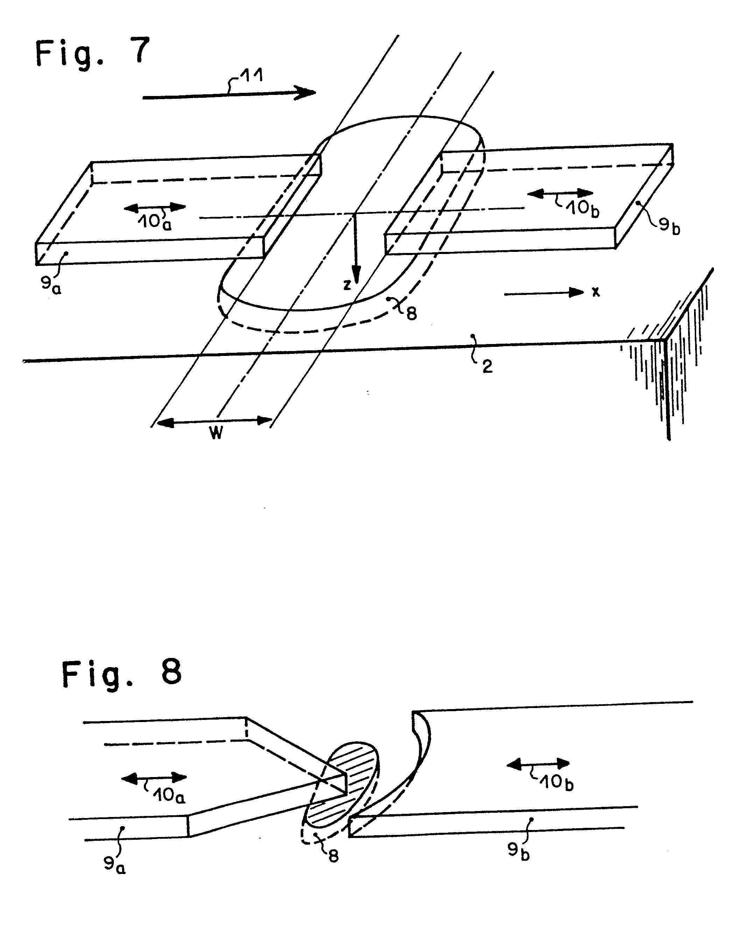

Die Fig. 7 zeigt ein Beispiel einer Anordnung mit zwei rechteckförmigen Filmen 9a und 9b mit den parallelen, leichten Achsen 10a und 10b, unter deren Trennungs-Luftspalt sich die empfindliche Zone 8 befindet, und die beide so angeordnet sind, dass sich einer in der Verlängerung des anderen befindet. Die Feldverteilung im Luftspalt zwischen zwei hinreichend langen Filmen ist annähernd gleich derjenigen eines Einzelfilms von der Länge W dieses Luftspaltes.

In der Mitte des Luftspaltes ergeben sich im Halbleiter-Magnetfeldsensor je nach Länge des Luftspaltes W = 20 µm bis 40 µm und je nach Tiefe z = 0 bis 10 µm Magnetinduktionen $\overrightarrow{B_f}$ im Bereich von 5 bis 15 Gauss. Also hat diese Anordnung eine ähnliche Empfindlichkeit ($\Delta V$ = 10 bis 30 mV) wie diejenige mit einem einzigen Film. ein technologischer Vorteil ist, das man grössere (insbesondere längere) Filme verwenden kann.

Die Fig. 8 zeigt eine feldfokussierende Filmgeometrie, die ebenfalls aus zwei Filmen 9a und 9b besteht, die ähnlich wie in der Fig. 7 angeordnet sind, nur dass hier die beiden am Luftspalt angrenzenden Enden der Filme nicht parallel verlaufen, sondern dass das Ende des einen Films 9 dreieckig spitz und das Ende des anderen Films 9b konkav abgerundet ausgebildet ist.

Die bisher beschriebenen Magnetfeldsensoren können als Strom-Messwandler am Eingang von Elektrizitätszählern eingesetzt werden zum Messen des verbrauchten elektrischen Stromes. Dieser Strom-Messwert dient dann anschliessend in Zusammenhang mit einem Spannungs-Messwert zur Ermittlung der verbrauchten elektrischen Energie.

Es gibt grundsätzlich zwei Varianten A und B, solche Elektrizitätszähler elektronisch zu realisieren.

Die Variante A ist in der DE-OS 29 48 762 beschrieben. In dieser Variante A wird das vom verbrauchten und zu messenden Strom erzeugte Magnetfeld mit Hilfe eines Referenz-Magnetfeldes abgetastet und die Nullwerte der Differenz beider Magnetfelder elektronisch ausgewertet. Das Referenz-Magnetfeld ist z.B. sägezahnförmig und wird z.B. mittels eines Referenzstromes erzeugt. Der Referenzstrom und der verbrauchte zu messende Strom durchfliessen je eine auf die Oberfläche des Magnetfeldsensors aufgetragene Flachspule oder je einen Flachleiter, der in der Nähe der Oberfläche des Magnetfeldsensors und parallel zu dieser angeordnet ist. Der Flachleiter kann auch U-förmig gebogen sein und den in einem Gehäuse montierten Magnetfeldsensor U-förmig umgeben.

Die Variante B ist in der DE-OS 31 33 908 beschrieben. In dieser Variante B wird das vom verbrauchten und zu messenden Strom erzeugte Magnetfeld mit Hilfe eines Kompensationsmagnetfeldes kompensiert und ein dieses Kompensationsmagnetfeld erzeugender Kompensationsstrom, der von einem Regelkreis geliefert wird, anschliessend elektronisch ausgewertet. Zur Erzeugung der zugehörigen Magnetfelder durchfliessen der zu messende Strom und der Kompensationsstrom je einen Flachleiter, der in der Nähe der Oberfläche des Magnetfeldsensors angeordnet ist, oder je eine Flachspule, die auf die Oberfläche des Magnetfeldsensors aufgetragen ist. In einer bevorzugten Anordnung sind auch hier die Flachleiter U-förmig gebogen und umgeben den in einem Gehäuse montierten Magnetfeldsensor U-förmig.

In allen Varianten sind die benötigten elektronischen Schaltungen vorzugsweise in dem gleichen Substrat integriert, in das auch der Magnetfeldsensor intergriert ist, so dass im Idealfall nur eine einzige gemeinsame integrierte Schaltung vorhanden ist.

Zwecks Verdichtung der Magnetfelder wird das den Magnetfeldsensor enthaltene Substrat in bevorzugten Anordnungen im oder in der unmittelbaren Nähe vom Luftspalt eines Magnetkernes mit seiner Oberfläche parallel zu den Magnetfeldern angeordnet, z.B. gemäss einer der in der DE-OS 29 18 483 beschriebenen Montagemethoden. In diesen Fällen genügt es, ein dort verwendetes Substrat mit darauf montiertem Magnetfilm durch den Magnetfeldsensor zu ersetzen.

Bisher wurde angenommen, dass der gesamte verbrauchte Strom im Magnetfeldsensor gemessen wird. Ist dieser Strom jedoch sehr gross, genügt es, einen konstanten und bekannten Bruchteil dieses Stromes dem Magnetfeldsensor in Form eines Magnetfeldes zuzuführen.

Dies geschieht nach einer der drei nachfolgenden Methoden:

Bei einer ersten, unter anderem in der DE-PS 30 08 308 beschriebenen Methode mit Stromteiler wird ein Teil des zu messenden Stromes mit Hilfe eines Shunts vom Magnetfeldsensor ferngehalten.

Bei einer zweiten, in der US-PS 42 40 059 beschriebenen Brücken-Methode, wird der zu messende Strom einer Messbrücke dermassen zugeführt, dass nur der im Diagonalzweig der Messbrücke fliessende Teil des zu messenden Stromes den Magnetfeldsensor erreicht und von diesem ausgewertet wird.

Eine dritte, in der Internationalen Patentanmeldung WO 83/01 535 beschriebene Methode sieht vor, den zu messenden Strom einem Stromwandler zuzuführen, dessen Primärwicklung aus zwei gegensinnig von Strömen durchflossenen und annähernd gleiche Widerstände aufweisenden Leitern besteht.

**Patentansprüche**

1. Magnetfeldsensor mit einem Magnetotransistor, dessen schwach mit Fremdatomen dotierte Basis-Schicht (2) mindestens einen stark mit Fremdatomen dotierten Basis-Kontakt (4) besitzt, wobei eine Emitter-Schicht (6), eine Kollektor-Schicht (5) und der Basis-Kontakt (4) nebeneinander auf einer Linie angeordnet sind, die Basis-schicht (2) als Wanne in einem schwach mit Fremdatomen dotiertem Siliziumsubstrat (1) vom umgekehrten Material-Leitfähigkeitstyp an dessen Oberfläche enthalten ist, ein Kollektorsekundärkontakt (3) ausserhalb der Wanne an der Oberfläche im Siliziumsubstrat (1) vorhanden ist, an den eine Spannung ($V_{DD}$) zu legen ist, die den P/N-Übergang (2; 1) zwischen der Basis-Schicht (2) und dem Siliziumsubstrat (1) in Sperrichtung polt, und die Dicke und/oder die Dotierung der Emitter-Schicht (6) so bemessen ist, dass ihre Resistivität grösser als 100 Ohm pro Quadrat ist, dadurch gekennzeichnet, dass ein NiFe- oder Ni-Co-Film (9) ohne elektrische Verbindung unmittelbar oberhalb der feldempfindlichen Zone (8) des Magnetotransistors derart aufgetragen ist, dass eine leichte Achse (10) räumlich senkrecht zur Stromflussrichtung des Magnetotransistors verläuft, der selber ein Detektor der durch den Film erzeugten Magnetinduktion ($\vec{B_f}$) ist, und dass der NiFe- bzw. NiCo-Film (9) unter Ausnutzung seiner Magnetinduktion/Magnetfeld-Hystereseschaltkennlinie ein Nullpunktschalter ist.

2. Magnetfeldsensor nach Anspruch 1, dadurch gekennzeichnet, dass zwei durch einen Luftspalt getrennte Filme (9a, 9b) so angeordnet sind, dass sich einer in der Verlängerung des anderen befindet, dass ihre leichten Achsen (10a, 10b) parallel sind und dass der Luftspalt sich oberhalb der feldempfindlichen Zone (8) des Magnetotransistors befindet.

3. Magnetfeldsensor nach Anspruch 2, dadurch gekennzeichnet, dass die beiden Filme (9a, 9b) rechteckförmig sind.

4. Magnetfeldsensor nach Anspruch 2, dadurch gekennzeichnet, dass die beiden am Luftspalt angrenzenden Enden der Filme (9a, 9b) eine feldfokussierende Filmgeometrie bilden.

5. Magnetfeldsensor nach Anspruch 4, dadurch gekennzeichnet, dass das Ende des einen Films (9a) dreieckig spitz und das gegenüberliegende Ende des anderen Films (9b) konkav abgerundet ausgebildet ist.

6. Magnetfeldsensor nach einem der Ansprüche 1 bis 5, dadurch gekennzeichnet, dass er zusammen mit einem zweiten identischen und räumlich parallel angeordneten Magnetotransistor (13), der keinen Film besitzt, in einem Differenzverstärker angeordnet ist.

7. Verwendung eines Magnetfeldsensors nach einem der Ansprüche 1 bis 6 im Stromeingangswandler eines elektronischen Elektrizitätszählers zum Vergleichen eines Magnetfeldes, das der zu messende Strom erzeugt, mit einem Referenzmagnetfeld.

8. Verwendung eines Magnetfeldsensors nach einem der Ansprüche 1 bis 6 zu dem im Anspruch 7 genannten Zweck mit der Massgabe, dass alle Magnetfelder mittels Strömen erzeugt sind, die Flachleiter, die in der Nähe der Oberfläche des Magnetfeldsensors und parallel zu dieser angeordnet sind, oder Flachspulen durchfliessen, die auf die Oberfläche des Magnetfeldsensors aufgetragen sind.

9. Verwendung nach Anspruch 8 mit der Massgabe, dass die Flachleiter U-förmig gebogen sind und den in einem Gehäuse montierten Magnetfeldsensor U-förmig umgeben.

10. Verwendung eines Magnetfeldsensors nach einem der Ansprüche 1 bis 6 zu dem im Anspruch 7 genannten Zweck mit der Massgabe, dass das den Magnetfeldsensor enthaltende Substrat im oder in der unmittelbaren Nähe vom Luftspalt eines Magnetkerns mit seiner Oberfläche parallel zu den Magnetfeldern angeordnet ist.

**Claims**

1. A magnetic field sensor comprising a magnetotransistor whose base layer (2) which is weakly doped with impurity atoms has at least one base contact (4) which is heavily doped with impurity atoms, wherein an emitter layer (6), a collector layer (5) and the base contact (4) are arranged side by side on a line, the base layer (2) is contained in the form of a well in a silicon substrate (1) which is weakly doped with impurity atoms, of opposite material conductivity type, at the surface thereof, a collector secondary contact (3) is provided outside the well at the surface in the silicon substrate (1) and a voltage ($V_{DD}$) is to be applied thereto, which biases the P/N-junction (2; 1) between the base layer (2) and the silicon substrate (1) in the reverse direction, and the thickness and/or doping of the emitter layer (6) is such that its resistivity is greater than 100 ohms per square metre, characterised in that an NiFe- or NiCo-film (9) is applied without electrical connection directly above the field-sensitive zone (8) of the magnetotransistor in such a way that its easy axis (10) extends spatially perpendicularly to the current flow direction of the magnetotransistor which itself is a detector of the magnetic induction $(\vec{B_f})$ produced by the film, and that the NiFe- or NiCo-film (9), utilising its magnetic induction/magnetic field hysteresis switching characteristic, is a zero point switch.

2. A magnetic field sensor according to claim 1 characterised in that two films (9a, 9b) which are separated by an air gap are so arranged that one is disposed to extend in line with the other, that their easy axes (10a, 10b) are parallel and that the air gap is above the field-sensitive zone (8) of the magnetotransistor.

3. A magnetic field sensor according to claim 2 characterised in that the two films (9a, 9b) are rectangular.

4. A magnetic field sensor according to claim 2 characterised in that the two ends of the films (9a, 9b), said ends adjoining the air gap, form a field-focussing film geometry.

5. A magnetic field sensor according to claim 4 characterised in that the end of the one film (9a) is of a triangular pointed configuration and the oppositely disposed end of the other film (9b) is of a concavely rounded configuration.

6. A magnetic field sensor according to one of claims 1 to 5 characterised in that it is arranged in a differential amplifier, together with a second identical magnetotransistor (13) which is arranged spatially parallel and which does not have any film.

7. Use of a magnetic field sensor according to one of claims 1 to 6 in the current input transformer of an electronic electricity meter for comparison of a magnetic field which is produced by the current to be measured, with a reference magnetic field.

8. Use of a magnetic field sensor according to one of claims 1 to 6 for the purpose set forth in claim 7, with the proviso that all magnetic fields are produced by means of currents which flow through flat conductors which are arranged in the vicinity of the surface of the magnetic field sensor and parallel to said surface, or flat coils which are applied to the surface of the magnetic field sensor.

9. Use according to claim 8 with the proviso that the flat conductors are bent in a U-shape and surround in a U-shape the magnetic field sensor which is mounted in a housing.

10. Use of a magnetic field sensor according to one of claims 1 to 6 for the purpose set forth in claim 7 with the proviso that the substrate containing the magnetic field sensor is arranged in or in the direct vicinity of the air gap of a magnetic core with its surface parallel to the magnetic fields.

**Revendications**

1. Détecteur de champ magnétique comportant un magnétotransistor, dont la couche de base (2) faiblement dopée par des atomes étrangers possède au moins un contact de base (4) fortement dopé par des atomes étrangers, et dans lequel une couche d'émetteur (6), une couche de collecteur (5) et le contact de base (4) sont disposés côte-à-côte sur une ligne, la couche de base (2) est disposée sous la forme d'une cuvette dans un substrat en silicium (1) faiblement dopé par des atomes étrangers et possédant un type de conductivité de matériau inverse, dans la surface de ce substrat, un contact secondaire de collecteur (3) qui est situé à l'extérieur de la cuvette au niveau de la surface dans le substrat en silicium (1) et auquel peut être appliquée une tension ($V_{DD}$) qui polarise en inverse la jonction P/N (2; 1) située entre la couche de base (2) et le substrat en silicium (1), et l'épaisseur et/ou le dopage de la couche d'émetteur (6) est dimensionné de telle sorte que sa résistivité est supérieure à 100 ohms par carré, caractérisé en ce qu'une pellicule (9) de NiFe ou de NiCo est déposée directement sur la zone photosensible (8), sans aucune liaison électrique, que son axe facile (10) est perpendiculaire dans l'espace à la direction du flux de courant du magnétotransistor, qui est lui-même un détecteur de l'induction magnétique $(\vec{B_f})$ produite par la pellicule, et que la pellicule (9) de NiFe ou de NiCo constitue, moyennant l'utilisation de sa courbe caractéristique de commutation induction magnétique/champ magnétique, un interrupteur à zéro.

2. Détecteur de champ magnétique selon la revendication 1, caractérisé en ce que deux pellicules (9a, 9b) séparées par un entrefer sont disposées de telle sorte que l'une est située dans le prolongement de l'autre, que leurs axes d'aimantation facile (10a, 10b) sont parallèles et que l'entrefer est situé au-dessus de la zone (8), sensible au champ, du magnétotransistor.

3. Détecteur de champ magnétique selon la revendication 2, caractérisé en ce que les deux pellicules (9a, 9b) sont rectangulaires.

4. Détecteur de champ magnétique selon la revendication 2, caractérisé en ce que les deux extrémités, limitant l'entrefer, des pellicules (9a, 9b) forment un dispositif géométrique à pellicules focalisant le champ.

5. Détecteur de champ magnétique selon la revendication 4, caractérisé en ce que l'extrémité d'une pellicule (9a) possède une forme triangulaire pointue et que l'extrémité opposée de l'autre pellicule (9b) possède une forme arrondie concave.

6. Détecteur de champ magnétique selon l'une des revendications 1 à 5, caractérisé en ce qu'il est disposé, de concert avec un second magnétotransistor identique (13) monté parallèlement dans l'espace et ne possédant aucune pellicule, dans un amplificateur différentiel.

7. Utilisation d'un détecteur de champ magnétique selon l'une des revendications 1 à 6 dans un transformateur de courant d'entrée d'un compteur électronique d'électricité pour la comparaison d'un champ magnétique, qui produit le courant à mesurer, à un champ magnétique de référence.

8. Utilisation d'un détecteur de champ magnétique selon l'une des revendications 1 à 6, pour le but indiqué dans la revendication 7, avec comme disposition le fait que tous les champs magnétiques sont produits au moyen due courant, qui circulent dans des conducteurs plats, qui sont disposés à proximité de la surface du détecteur de champ magnétique et parallèlement à cette surface, ou dans des bobines plates qui sont disposées sur la surface du détecteur de champ magnétique.

9. Utilisation selon la revendication 8, avec la disposition selon laquelle les conducteurs plats sont repliés en forme de U et entourent, à la manière d'un U le détecteur de champ magnétique monté dans un boîtier.

10. Utilisation d'un détecteur de champ magnétique selon l'une des revendications 1 à 6, pour le but indiqué dans la revendication 7, avec la disposition consistant en ce que le substrat contenant le détecteur de champ magnétique est disposé dans ou à proximité immédiate de l'entrefer d'un noyau magnétique, de telle sorte que sa surface est parallèle aux champs magnétiques.

Fig. 1

Fig. 2

Fig. 3

# Fig. 4

# Fig. 5

# Fig. 6

# Fig. 7

# Fig. 8